# FASCICULE DE BREVET EUROPEEN

(11) **EP 4 203 296 B1**
(45) Date de publication et mention de la délivrance du brevet: **14.08.2024**
(21) Numéro de dépôt: 21217741.4
(22) Date de dépôt: 24.12.2021
(51) Int. Cl.: H02P 7/06, H02P 6/08, G04C 3/14, G04C 3/00, G04C 3/16

(54) **DISPOSITIF DE COMMANDE D'UN MOTEUR À ROTATION CONTINUE**
VORRICHTUNG ZUR STEUERUNG EINES KONTINUIERLICH DREHENDEN MOTORS
DEVICE FOR CONTROLLING A MOTOR WITH CONTINUOUS ROTATION

(43) Date de publication de la demande: 28.06.2023
(73) Titulaire: The Swatch Group Research and Development Ltd, 2074 Marin (CH)
(72) Inventeur: GERMIQUET, Christophe, 2515 Prêles (CH); BORN, Jean-Jacques, 1110 Morges (CH)
(74) Mandataire: ICB SA

(56) Documents cités:
- EP-A1- 3 663 871
- EP-A1- 3 663 872
- EP-A1- 3 664 280

## Description

### Domaine technique de l'invention

La présente invention concerne un dispositif de commande de l'alimentation électrique d'un moteur à rotation continue. En particulier, l'invention concerne une pièce d'horlogerie, du type électromécanique, comprenant un moteur à rotation continue et à courant continu, lequel est configuré pour pouvoir être incorporé dans cette pièce d'horlogerie, et un tel dispositif de commande.

### Arrière-plan technologique

On connaît du document EP 3663872 un dispositif de commande de l'alimentation d'un moteur à rotation continue, en particulier pour une application horlogère, agencé pour pouvoir contrôler la rotation du rotor de ce moteur en permettant une variation de la vitesse de ce rotor qui ne soit pas brusque et qui reste dans des limites avantageuses pour la bonne marche du moteur même dans des conditions défavorables ou suite à un événement perturbateur, tout en contrôlant, sur la durée, le nombre moyen de rotations / tours du rotor par unité de temps afin de garantir une indication correcte de l'heure courante.

Divers modes ou régimes de fonctionnement sont prévus dans le document susmentionné, en particulier en fonction de la charge entraînée par le moteur à un moment donné, des conditions d'utilisation dans lequel se trouve le moteur, notamment de perturbations auxquelles il est soumis, et d'une dérive temporelle du nombre de tours effectués par le moteur, depuis un temps initial, relativement à une valeur de consigne donnée pour la vitesse moyenne de rotation (à laquelle correspond un nombre de tours du rotor par unité de temps). Dans un mode de fonctionnement divulgué dans ce document, à chaque cycle du procédé de régulation de la vitesse du rotor, soit une impulsion électrique 'basse énergie' est générée, soit aucune impulsion n'est générée. Il s'agit d'un mode de fonctionnement normal pour le moteur, c'est-à-dire dans des conditions de fonctionnement usuelles, sans grandes perturbations. On notera que la présente invention concerne principalement un tel mode ou régime de fonctionnement normal pour lequel des impulsions électriques 'basse énergie' sont successivement fournies au stator du moteur à rotation continue, en nombre variable par période temporelle donnée, pour entraîner en rotation son rotor.

Pour générer des impulsions électriques 'basse énergie' telles que mentionnées dans le document EP 3663872, la personne du métier peut utiliser en particulier l'enseignement du document EP 3664280, qui indique une méthode avantageuse pour un moteur dont le stator est formé de deux bobines et le rotor est muni d'un certain nombre d'aimants permanents (plus généralement de pôles magnétiques permanents couplés magnétiquement avec le stator) et l'enseignement du document EP 3663871 qui décrit un diviseur de tension particulièrement efficace pour diviser une première tension d'alimentation, fournie notamment par une batterie fournissant une tension d'alimentation comprise entre 1.2 V et 1.5 V, laquelle peut descendre en dessous de cette plage selon l'état de la batterie, en une moindre tension (deuxième tension d'alimentation) fournie au stator du moteur dans le cas de la génération de séries d'impulsions électriques 'basse énergie' ayant une durée constante donnée.

Le document EP 3663871 vise à réduire la consommation électrique du moteur, ce qui est obtenu en divisant la première tension d'alimentation fournie par la batterie en une deuxième tension inférieure fixe qui est appliquée aux bornes du stator. En d'autres termes, le courant injecté dans les inductances (bobines) du stator est minimisé et par conséquent les pertes résistives peuvent également être minimisées. A titre d'exemple, le diviseur de tension divulgué divise par trois la première tension d'alimentation fournie par la batterie. La sélection d'un diviseur de tension par trois résulte de considérations relatives à la valeur maximum de la tension induite dans les deux bobines du stator, en fonctionnement normal du moteur, une division par trois assurant une certaine marge pour que les impulsions électriques restent motrices, c'est-à-dire pour que la deuxième tension d'alimentation reste au-dessus de la tension induite maximum dans le stator, mais avec une différence entre ces deux tensions qui soit bien plus petite que dans le cas où la première tension d'alimentation serait directement appliquée au stator.

### Résumé de l'invention

La présente invention a pour objectif de fournir un dispositif de commande de l'alimentation d'un moteur à rotation continue, en particulier incorporé dans une pièce d'horlogerie, qui permette d'alimenter ce moteur de la manière la plus efficace possible en limitant au maximum sa consommation d'énergie au moins dans un mode ou régime de fonctionnement donné.

La présente invention concerne un dispositif de commande de l'alimentation d'un moteur à rotation continue qui est formé par un stator et un rotor, le stator comprenant au moins une bobine d'alimentation et le rotor portant au moins un aimant permanent magnétiquement couplé à ladite au moins une bobine d'alimentation lorsque le rotor tourne. Ce dispositif de commande est agencé pour être alimenté en énergie électrique par une unité d'alimentation, fournissant une première tension d'alimentation, et il comprend un diviseur de tension agencé pour pouvoir diviser cette première tension d'alimentation et fournir au stator une deuxième tension d'alimentation inférieure à la première tension d'alimentation. Le dispositif de commande est agencé de manière à engendrer, dans un mode ou régime de fonctionnement donné du moteur, des impulsions électriques qui sont des impulsions électriques motrices fournies au stator avec la deuxième tension d'alimentation pour entraîner le rotor, le nombre de ces impulsions électriques par intervalle de temps défini étant variable en fonction notamment de la charge appliquée au moteur. Le dispositif de commande comprend un circuit logique qui est agencé pour pouvoir : - compter les nombres d'impulsions électriques dans des périodes temporelles successives ; - périodiquement sélectionner une valeur de tension, parmi ladite pluralité de valeurs différentes prévues pour la deuxième tension d'alimentation, en fonction d'un nombre d'impulsions électriques compté ou d'une succession de nombres d'impulsions électriques comptés ; et - commander le diviseur de tension pour que ce diviseur de tension fournisse la deuxième tension d'alimentation avec la valeur de tension sélectionnée lors de la génération d'impulsions électriques suite à la sélection de cette valeur de tension. Le circuit logique est agencé de manière que, lors de chaque nouvelle sélection :
- la valeur de la deuxième tension d'alimentation est diminuée, si cette valeur est supérieure à une valeur inférieure donnée, lorsqu'un dernier nombre d'impulsions électriques calculé ou une première fonction croissante de ce dernier nombre est inférieur à un premier seuil déterminé, ou lorsque la succession de nombres d'impulsions électriques calculés incluant le dernier nombre ou de la première fonction croissante de chacun de ces nombres valide un premier critère de sélection pour lequel au moins un nombre parmi la succession de nombres ou la première fonction croissante de ce nombre est inférieur à un premier seuil déterminé ;
- la valeur de la deuxième tension d'alimentation est augmentée, si cette valeur est inférieure à une valeur supérieure donnée, lorsqu'un dernier nombre d'impulsions électriques calculé ou la première fonction croissante de ce dernier nombre est supérieur à un deuxième seuil déterminé, ou lorsque la succession de nombres d'impulsions électriques calculés incluant le dernier nombre ou de la première fonction croissante de chacun de ces nombres valide un deuxième critère de sélection pour lequel au moins un nombre parmi la succession de nombres ou la première fonction croissante de ce nombre est supérieur à un deuxième seuil déterminé.

Dans un mode de réalisation principal, le circuit logique est agencé pour pouvoir déterminer dans quelle plage de valeurs, parmi une pluralité de plages de valeurs déterminées, se trouve un nombre d'impulsions électriques calculé ou la première fonction croissante de ce nombre ou une deuxième fonction d'une succession de nombres d'impulsions électriques calculés ou de la première fonction croissante de chacun de ces nombres, et pour pouvoir périodiquement sélectionner une valeur de tension, parmi ladite pluralité de valeurs différentes prévues pour la deuxième tension d'alimentation, en fonction de la dernière plage de valeurs déterminée.

Selon une variante générale du mode de réalisation principal, la pluralité de plages de valeurs comprend une première plage de valeurs ayant comme limite supérieure ledit premier seuil, une deuxième plage de valeurs ayant comme limite inférieure ledit deuxième seuil, et une troisième plage de valeurs située entre les première et deuxième plages de valeurs et ayant comme limites inférieure et supérieure respectivement les premier et deuxième seuils. Dans cette variante générale, le circuit logique est agencé de manière que, lors de chaque nouvelle sélection :
- lorsque le dernier nombre d'impulsions électriques calculé ou la première fonction croissante de ce dernier nombre ou la deuxième fonction de la succession de nombres d'impulsions électriques calculés incluant le dernier nombre ou de la première fonction croissante de chacun de ces nombres est comprise dans la première plage de valeurs, la valeur de la deuxième tension d'alimentation est diminuée si cette valeur est supérieure à ladite valeur inférieure ;
- lorsque le dernier nombre d'impulsions électriques calculé ou la première fonction croissante de ce dernier nombre ou la deuxième fonction de la succession de nombres d'impulsions électriques calculés incluant le dernier nombre ou de la première fonction croissante de chacun de ces nombres est comprise dans la deuxième plage de valeurs, la valeur de la deuxième tension d'alimentation est augmentée si cette valeur est inférieure à ladite valeur supérieure ;
- lorsque le dernier nombre d'impulsions électriques calculé ou la première fonction croissante de ce dernier nombre ou la deuxième fonction de la succession de nombres d'impulsions électriques calculés incluant le dernier nombre ou de la première fonction croissante de chacun de ces nombres est comprise dans la troisième plage de valeurs, la valeur de la deuxième tension d'alimentation est maintenue à la valeur résultant de la sélection précédente.

Dans un mode de réalisation avantageux de l'invention, le dispositif de commande comprend un circuit de mesure agencé pour pouvoir détecter et compter, lorsque le rotor tourne, les alternances ou périodes d'une tension induite dans ladite bobine d'alimentation ou dans ladite au moins une bobine d'alimentation, les périodes temporelles successives étant chacune définies par un nombre donné d'alternances ou de périodes successives détectées dans la tension induite. Le circuit logique est agencé pour pouvoir déterminer un taux d'impulsions électriques par alternance ou période de la tension induite pour chacune des périodes temporelles successives, le taux étant égal à la division du nombre d'impulsions électriques compté dans la période temporelle considérée par le nombre donné d'alternances ou de périodes dans cette période temporelle, le taux définissant la première fonction croissante du nombre d'impulsions électriques calculé.

Selon un mode de réalisation préféré de l'invention, le diviseur de tension comprend un circuit d'interrupteurs agencé entre, d'une part, le stator et, d'autre part, l'unité d'alimentation fournissant la première tension d'alimentation et la masse du dispositif de commande, ce diviseur de tension étant agencé pour pouvoir diviser la première tension d'alimentation sélectivement par une pluralité de nombres entiers qui sont supérieurs à un.

Dans une variante avantageuse du mode de réalisation préféré, le diviseur de tension comprend N condensateurs Cₙ, n = 1 à N , où N est un nombre entier supérieur à 1. Ensuite, le circuit logique est agencé pour pouvoir ouvrir et fermer les interrupteurs du circuit d'interrupteurs de manière à générer des séries desdites impulsions électriques, chacune comprenant S+1 impulsions électriques successives où S est un nombre entier sélectionné entre 1 et N, chacune étant générée de la manière suivante :
- premièrement, l'unité d'alimentation est connectée via le stator, pour ladite durée d'impulsion, à un premier condensateur C₁ parmi les N condensateurs, auquel elle fournit la première tension d'alimentation, pour générer une première impulsion électrique de la série d'impulsions considérée ;
- ensuite, lorsque que le nombre S est égal 2, le stator est connecté, pour la durée d'impulsion, entre le condensateur C₂ et le condensateur C₁ pour générer une deuxième impulsion électrique ; ou, lorsque que le nombre S est supérieur à 2, le stator est connecté successivement, chaque fois pour la durée d'impulsion, entre un condensateur C_{J} et un condensateur C_{J-1} parmi S condensateurs, compris dans les N condensateurs, avec J variant de 2 à S, pour générer successivement S-1 impulsions électriques ;
- finalement, le stator est connecté, pour la durée d'impulsion, entre le condensateur C_{S} et la masse pour générer une dernière impulsion électrique de la série d'impulsions électriques considérée.

Le nombre S peut être à nouveau sélectionné par le circuit logique lors de chaque dite nouvelle sélection de ladite valeur de tension. La pluralité de valeurs différentes prévues pour la deuxième tension d'alimentation correspond respectivement à la pluralité de tensions définie par la première tension d'alimentation divisée par m, où m = 2 à N+1. De préférence, les N condensateurs Cn, n = 1 à N, ont sensiblement une même capacité. En particulier, le nombre N est prévu entre trois et six, y compris.

On remarquera que, dans ledit mode ou régime de fonctionnement donné du moteur, pour que les impulsions électriques soient en tout temps motrices, la première tension d'alimentation divisée par N+1 est supérieure à la valeur absolue d'une tension induite maximale engendrée normalement au travers du stator.

Dans une variante préférée, le dispositif de commande est agencé de manière que chaque impulsion électrique est engendrée lorsque la tension induite au travers du stator est sensiblement égale à la tension induite maximale.

Dans une variante générale, les impulsions électriques présentent dans ledit mode ou régime de fonctionnement donné du moteur, au moins par intervalle de temps s'étendant sur des dizaines tours du rotor, une durée d'impulsion constante.

Dans un mode de réalisation général, le moteur est un moteur à courant continu alimenté par une pile ou batterie.

Dans une variante spécifique, le dispositif de commande est agencé de manière à asservir la vitesse moyenne de rotation du rotor du moteur à une vitesse de consigne donnée.

L'invention concerne aussi une pièce d'horlogerie comprenant un moteur à rotation continue et un dispositif de commande de l'alimentation de ce moteur tel que défini précédemment.

Grâce aux caractéristiques de l'invention, les pertes résistives, nommées aussi pertes par effet Joule, peuvent être diminuées de manière optimale. Pour rappel, les pertes résistives résultent du fait que le passage d'un courant électrique à travers un conducteur produit de la chaleur. La première loi de Joule stipule que la puissance de chauffage P_{J} générée par un conducteur électrique est proportionnelle au produit de sa résistance R par le carré du courant I, soit P_{J} = R × I². Cependant, la puissance mécanique utile P_{mec} est proportionnelle au courant, et non à son carré. En effet, la puissance mécanique P_{mec} = kᵤ × w × I, où kᵤ est la constante de couple et w est la vitesse de rotation du rotor. L'invention permet de manière remarquable de réduire les pertes par effet Joule dans le moteur tout en assurant un fonctionnement correct et sûr du moteur, c'est-à-dire tout en fournissant une puissance mécanique suffisante notamment pour la charge à laquelle est soumis le moteur. Il en résulte un fonctionnement très efficace du moteur permettant de réduire au mieux sa consommation d'énergie électrique.

### Brève description des figures

L'invention sera décrite ci-après de manière plus détaillée à l'aide des dessins annexés, donnés à titre d'exemples nullement limitatifs, dans lesquels :
- la Figure 1 représente schématiquement un moteur à rotation continue et un dispositif de commande de l'alimentation de ce moteur ;
- la Figure 2 est un schéma électrique du stator dudit moteur à rotation continue et d'une variante d'un mode de réalisation préféré du dispositif de commande de l'alimentation de ce moteur selon l'invention ;
- la Figure 3 représente la tension induite dans chacune des deux bobines du stator et un signal de mesure dérivé d'une de ces deux tensions induites ;
- la Figure 4 est un tableau indiquant la gestion d'un circuit d'interrupteurs du dispositif de commande dans un mode de mesure ;
- la Figure 5 est un tableau indiquant la gestion d'un circuit d'interrupteurs du dispositif de commande dans un mode d'entraînement du moteur lors de la génération d'impulsions électriques positives ; et
- la Figure 6 est un tableau indiquant la gestion dudit circuit d'interrupteurs du dispositif de commande dans ledit mode d'entraînement du moteur lors de la génération d'impulsions électriques négatives.

### Description détaillée de l'invention

En référence aux Figures, on décrira ci-après un mode de réalisation préféré d'un dispositif de commande 2 selon l'invention pour l'alimentation d'un moteur 4 à rotation continue et à courant continu (en *anglais 'DC motor'* ), c'est-à-dire un moteur qui est alimenté sous une tension sensiblement constante lorsque le stator est alimenté pour entraîner en rotation le rotor.

Le moteur à rotation continue 4 est un petit moteur qui peut être dimensionné pour être incorporé dans une pièce d'horlogerie. Ce moteur 4 comprend un stator formé de deux bobines d'alimentation B1 et B2, sans noyau magnétique, et un rotor 6 formé par un arbre sur lequel sont montés un pignon 8, définissant une prise de force pour une charge entraînée par le moteur, et deux flasques 10 portant des aimants permanents 12a et 12b. Ces aimants présentent des polarités alternées du côté d'un espace intérieur, entre les deux flasques, dans lequel sont introduites partiellement les deux bobines B1 et B2, de sorte que les aimants sont magnétiquement couplés aux bobines du stator lorsque le rotor tourne.

Les deux bobines B1 et B2 sont reliées électriquement au dispositif de commande 2, lequel comprend un diviseur de tension, formé par un circuit d'interrupteurs 22 et une pluralité de capacités 24, un circuit logique 20 et un circuit de mesure 18. Le circuit d'interrupteurs est agencé entre, d'une part, le stator et, d'autre part, l'unité d'alimentation 16 et la masse du dispositif de commande. Le dispositif de commande est agencé pour être alimenté en énergie électrique par l'unité d'alimentation 16, en particulier une batterie, laquelle fournit une première tension d'alimentation V_{dd} au dispositif de commande. Le diviseur de tension est agencé pour pouvoir diviser la première tension d'alimentation V_{dd} sélectivement par une pluralité de nombres entiers qui sont supérieurs à un, comme ceci sera exposé plus en détails par la suite.

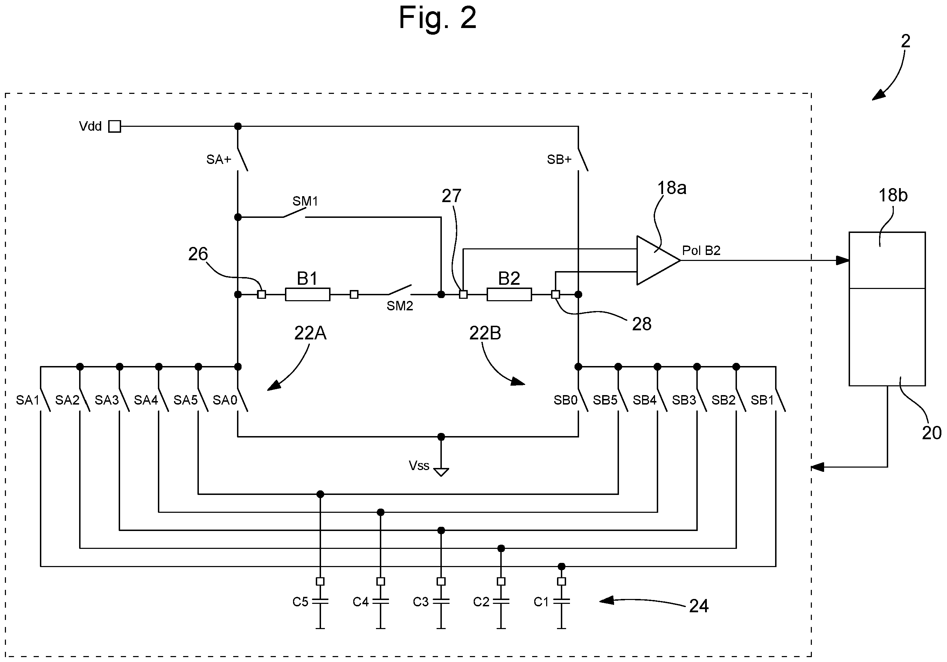

Dans la variante avantageuse représentée à la Figure 2, le circuit d'interrupteurs 22 comprend deux interrupteurs SA+ et SB+, agencés entre la borne d'alimentation qui reçoit la première tension d'alimentation de l'unité d'alimentation et respectivement les deux bornes 26 et 28 du stator, une première série d'interrupteurs 22A agencés entre la première borne 26 du stator et respectivement la masse et la pluralité de capacités 24, et une deuxième série d'interrupteurs 22B agencés entre la deuxième borne 28 du stator et respectivement la masse et la pluralité de capacités 24. Pour un moteur de petites dimensions, notamment du type horloger, les interrupteurs sont généralement formés par des transistors MOS. Dans une variante particulière, la pluralité de capacités est formée de cinq capacités C1 à C5. La première série d'interrupteurs 22A est formée de six interrupteurs SA0, SA1 à SA5, l'interrupteur SA0 étant relié à la masse alors que les cinq interrupteurs SA1 à SA5 sont respectivement reliés aux capacités C1 à C5. La deuxième série d'interrupteurs 22B est formée de six interrupteurs SB0, SB1 à SB5, l'interrupteur SB0 étant relié à la masse alors que les cinq interrupteurs SB1 à SB5 sont respectivement reliés aux capacités C1 à C5.

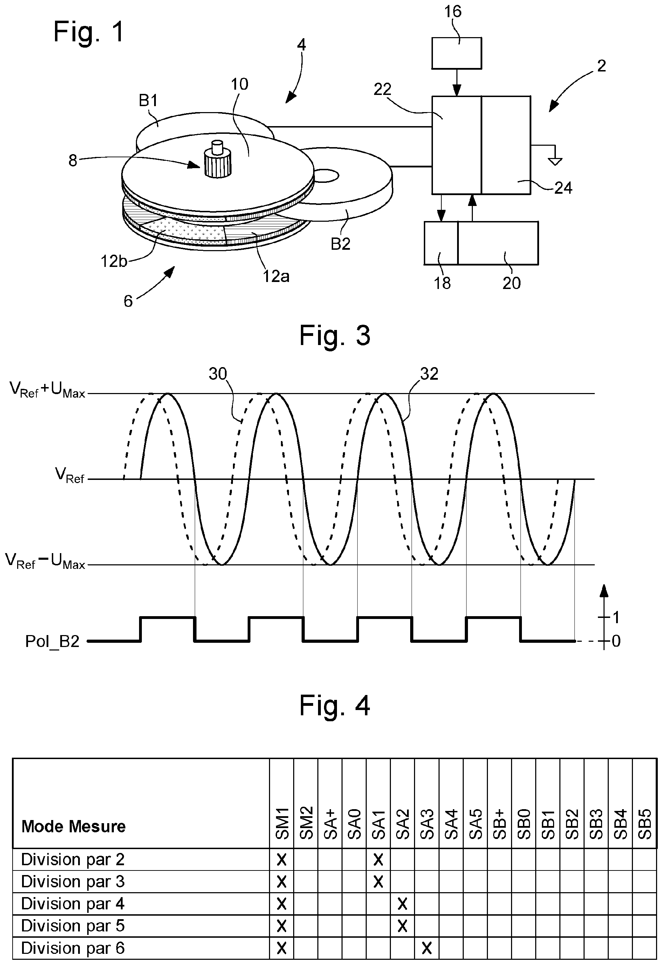

Le circuit de mesure est formé de deux interrupteurs SM1 et SM2 (dans une variante générale, il est prévu au moins un interrupteur), d'un comparateur 18a et d'un compteur 18b associé au circuit logique 20. Le comparateur 18a a deux entrées reliées respectivement aux première et seconde bornes 27 et 28 de la bobine B2 et il fournit, lorsque le rotor tourne, un signal digital Pol_B2 passant alternativement entre ses deux états '0' et '1' de manière sensiblement périodique (si la vitesse du rotor est constante, le signal digital est périodique). Le signal digital Pol_B2 indique la polarité instantanée de la tension induite 32 dans la bobine B2. A la Figure 3, laquelle représente en outre la tension induite 30 dans la bobine B1, l'état '0' du signal Pol_B2 correspond à une polarité négative de la tension induite 32 alors que l'état '1' du signal Pol_B2 correspond à une polarité positive de cette tension induite. Les transitions dans le signal digital Pol_B2 entre ses deux états déterminent des passages de la tension induite par une tension milieu, une tension inférieure à cette tension milieu étant définie comme une polarité négative alors qu'une tension supérieure à cette tension milieu est définie comme une polarité positive de la tension induite.

L'interrupteur SM2 permet d'interrompre momentanément la liaison électrique entre les deux bobines B1 et B2 agencées en série, et l'interrupteur SM1 permet de relier momentanément la première borne 27 de la bobine B2 à une tension de référence V_{Ref}, laquelle détermine la tension milieu de la tension induite U dans la bobine B2, cette tension de référence étant inférieure à la première tension d'alimentation V_{dd} (on décrira par la suite le fonctionnement d'un mode de mesure, nommé 'Mode Mesure'). Le compteur 18b est agencé pour pouvoir compter dans le signal digital Pol_B2 toutes les transitions entre ses deux états, correspondant respectivement aux deux polarités de ladite tension induite U, et compter ainsi un nombre d'alternances de cette tension induite, ou toutes les transitions vers un état donné, entre les deux états, du signal digital Pol_B2 et compter ainsi un nombre de périodes de la tension induite.

Le fonctionnement du dispositif de commande selon le mode de réalisation préféré sera décrit par la suite. De manière générale, le diviseur de tension est agencé pour pouvoir diviser la première tension d'alimentation V_{dd} et fournir au stator une deuxième tension d'alimentation qui est inférieure à cette première tension d'alimentation (tension de batterie V_{Bat}). Selon l'invention, le diviseur de tension est agencé pour pouvoir fournir la deuxième tension d'alimentation avec une pluralité de valeurs différentes. Ensuite, le dispositif de commande selon l'invention est agencé pour pouvoir engendrer, dans un mode ou régime de fonctionnement donné du moteur à rotation continue, des impulsions électriques qui sont des impulsions motrices fournies au stator avec ladite deuxième tension d'alimentation pour entraîner le rotor. Ces impulsions électriques ont donc une tension variable, laquelle est variée en fonction de critères exposés ci-après. Le nombre des impulsions électriques par intervalle de temps défini est variable en fonction notamment de la charge appliquée au moteur. Le circuit logique du dispositif de commande est agencé pour pouvoir 1) compter les nombres d'impulsions électriques dans des périodes temporelles successives ; 2) périodiquement sélectionner une valeur de tension, parmi la pluralité de valeurs différentes prévues pour la deuxième tension d'alimentation, en fonction d'un nombre d'impulsions électriques compté ou d'une succession de nombres d'impulsions électriques comptés ; et 3) commander le diviseur de tension de manière que ce diviseur de tension fournisse, suite à la sélection de ladite valeur de tension, la deuxième tension d'alimentation avec cette valeur de tension sélectionnée lors de la génération d'impulsions électriques. De manière générale, le circuit logique est agencé de manière que, lors de chaque nouvelle sélection d'une valeur de tension pour la deuxième tension d'alimentation :
- la valeur de la deuxième tension d'alimentation est diminuée, si cette valeur est supérieure à une valeur inférieure donnée, lorsqu'un dernier nombre d'impulsions électriques calculé ou une première fonction croissante de ce dernier nombre est inférieur à un premier seuil déterminé, ou lorsque la succession de nombres d'impulsions électriques calculés incluant le dernier nombre ou de la première fonction croissante de chacun de ces nombres valide un premier critère de sélection pour lequel au moins un nombre parmi la succession de nombres ou la première fonction croissante de ce nombre est inférieur à un premier seuil déterminé ;
- la valeur de la deuxième tension d'alimentation est augmentée, si cette valeur est inférieure à une valeur supérieure donnée, lorsqu'un dernier nombre d'impulsions électriques calculé ou la première fonction croissante de ce dernier nombre est supérieur à un deuxième seuil déterminé, ou lorsque la succession de nombres d'impulsions électriques calculés incluant le dernier nombre ou de la première fonction croissante de chacun de ces nombres valide un deuxième critère de sélection pour lequel au moins un nombre parmi la succession de nombres ou la première fonction croissante de ce nombre est supérieur à un deuxième seuil déterminé.

Des exemples pour le premier critère de sélection et le deuxième critère de sélection sont : 1) Un nombre d'impulsions électriques ou la première fonction croissante de ce nombre est inférieur au premier seuil, respectivement supérieur au deuxième seuil lors de deux périodes temporelles consécutives. 2) Un nombre d'impulsions électriques ou la première fonction croissante de ce nombre est inférieur au premier seuil, respectivement supérieur au deuxième seuil lors de deux périodes parmi cinq périodes temporelles successives, plus généralement lors de X périodes temporelles parmi X+Y périodes temporelles successives (X et Y étant des nombres entiers positifs non nuls).

Dans un mode de réalisation principal, le circuit logique est agencé pour pouvoir déterminer dans quelle plage de valeurs, parmi une pluralité de plages de valeurs déterminées, se trouve un nombre d'impulsions électriques calculé ou la première fonction croissante de ce nombre ou une deuxième fonction d'une succession de nombres d'impulsions électriques calculés ou de la première fonction croissante de chacun de ces nombres, et pour pouvoir périodiquement sélectionner une valeur de tension, parmi ladite pluralité de valeurs différentes prévues pour la deuxième tension d'alimentation, en fonction de la dernière plage de valeurs déterminée. La deuxième fonction susmentionnée est par exemple une moyenne arithmétique de la succession de nombres d'impulsions électriques calculés ou de la première fonction croissante de chacun de ces nombres. Dans un autre exemple, la deuxième fonction est la valeur maximale dans la succession de nombres d'impulsions électriques calculés ou de la première fonction croissante de chacun de ces nombres.

Dans un mode de réalisation avantageux de l'invention, le circuit de mesure du dispositif de commande est agencé pour pouvoir détecter et compter, lorsque le rotor tourne, les alternances ou périodes de la tension induite dans ladite bobine d'alimentation ou dans ladite au moins une bobine d'alimentation. Les périodes temporelles successives sont chacune définies par un nombre donné d'alternances ou de périodes successives détectées dans la tension induite. A titre d'exemples, le nombre d'alternances ou de périodes prévus pour une période temporelle correspond sensiblement à quelques secondes ou une minute. En général les périodes temporelles ont une durée sensiblement constante, plus précisément ici un même nombre d'alternances ou de périodes de la tension induite. Cependant, dans une variante particulière, les périodes temporelles peuvent varier. On peut par exemple alterner des périodes courtes et des périodes longues, ou varier la longueur des périodes temporelles en fonction du résultat obtenu par la ou les périodes temporelle(s) précédente(s). Les périodes temporelles peuvent se succéder sans interruption ou être périodiques avec des intervalles de temps sans mesure entre celles-ci.

Ensuite, le circuit logique est agencé pour pouvoir déterminer un taux d'impulsions électriques par alternance ou période de la tension induite susmentionnée pour chacune des périodes temporelles successives. Par définition, ledit taux est égal à la division du nombre d'impulsions électriques compté dans la période temporelle considérée par le nombre donné d'alternances ou de périodes dans cette période temporelle. Ce taux définit la première fonction croissante du nombre d'impulsions électriques calculé.

Dans une variante particulière, la pluralité de plages de valeurs comprend : - une plage inférieure du taux d'impulsions électriques ayant comme limite supérieure le premier seuil ; - une plage supérieure dudit taux ayant comme limite inférieure le deuxième seuil ; et - une plage intermédiaire dudit taux ayant comme limites inférieure et supérieure respectivement les premier et deuxième seuils. Le circuit logique est agencé de manière que, lors de chaque nouvelle sélection d'une valeur de tension pour la deuxième tension d'alimentation :
- lorsque le dernier taux d'impulsions électriques déterminé ou ladite deuxième fonction d'une succession de taux d'impulsions électriques déterminés incluant le dernier taux est compris dans la plage inférieure, la valeur de la deuxième tension d'alimentation est diminuée si cette valeur est supérieure à ladite valeur inférieure ;
- lorsque le dernier taux d'impulsions électriques déterminé ou la deuxième fonction d'une succession de taux d'impulsions électriques déterminés incluant le dernier taux est compris dans la plage intermédiaire, la valeur de la deuxième tension d'alimentation est maintenue à une valeur résultant de la sélection précédente ;
- lorsque le dernier taux d'impulsions électriques déterminé ou la deuxième fonction d'une succession de taux d'impulsions électriques déterminés incluant le dernier taux est compris dans la plage supérieure, la valeur de la deuxième tension d'alimentation est augmentée si cette valeur est inférieure à ladite valeur supérieure.

Par exemple, le premier seuil est égal à 50% et le deuxième seuil est égal à 75%, la plage intermédiaire du taux étant comprise entre 50% et 75%.

Dans le mode réalisation préféré, le dispositif de commande fonctionne alternativement dans deux modes, à savoir un mode 'Mesure'

(premier mode) et un mode 'Génération d'impulsions électriques' (second mode). Ces deux modes sont gérés par le circuit logique 20.

Dans la variante décrite aux figures, le diviseur de tension comprend cinq condensateurs Cₙ, n = 1 à 5, qui ont sensiblement une même capacité. Dans le mode ou régime de fonctionnement considéré du moteur, la première tension d'alimentation divisée par le nombre de capacités de la pluralité de capacités plus un, soit par six, est supérieure à la valeur absolue d'une tension induite maximale engendrée normalement au travers du stator. Le dispositif de commande est agencé de manière que chaque impulsion électrique est engendrée lorsque la tension induite au travers du stator est sensiblement égale à la tension induite maximale, en particulier lorsque la tension induite dans la bobine B2 est sensiblement égale en valeur absolue à U_{Max} (voir Figure 3). On notera que, dans les intervalles entre les impulsions électriques, le dispositif de commande est mis dans le mode 'Mesure' pour pouvoir déterminer les passages de la tension induite U dans la bobine B2 par la tension de référence V_{Ref}. Seulement lors de la génération de chacune des impulsions électriques motrices pour entraîner en rotation le rotor du moteur, le dispositif de commande est mis dans le mode 'Génération d'impulsions électriques'. Ainsi, le mode 'Génération d'impulsions électriques' est activé pour générer chaque impulsion électrique, et le mode 'Mesure' est activé au moins lorsque la tension induite dans la bobine B2, laquelle engendre le signal digital Pol_B2, approche de la tension de référence V_{Ref} et jusqu'à ce qu'elle atteigne et dépasse un peu cette tension de référence, plus précisément au moins jusqu'à ce que la transition dans le signal digital Pol_B2 en lien avec cet événement ait eu lieu.

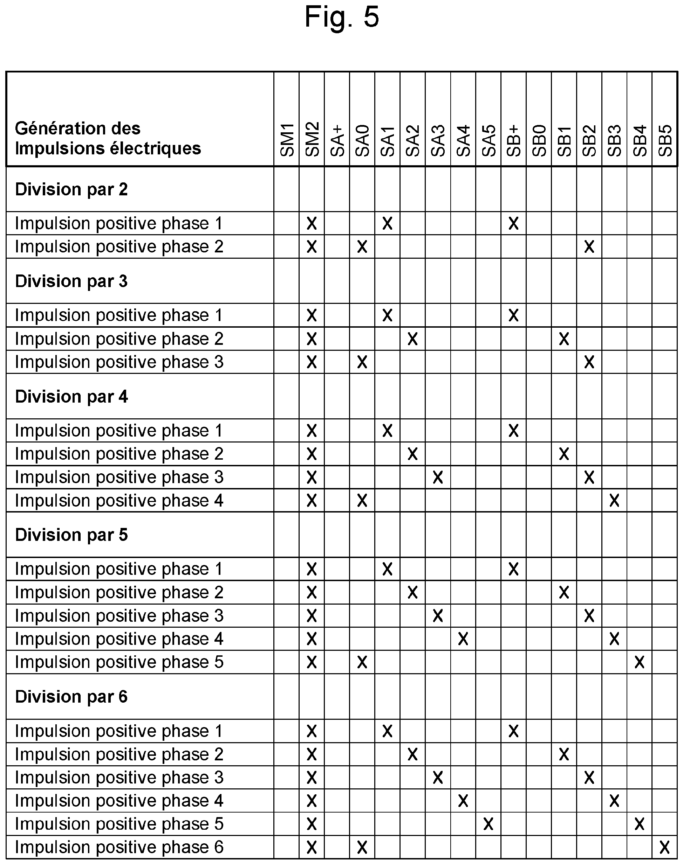

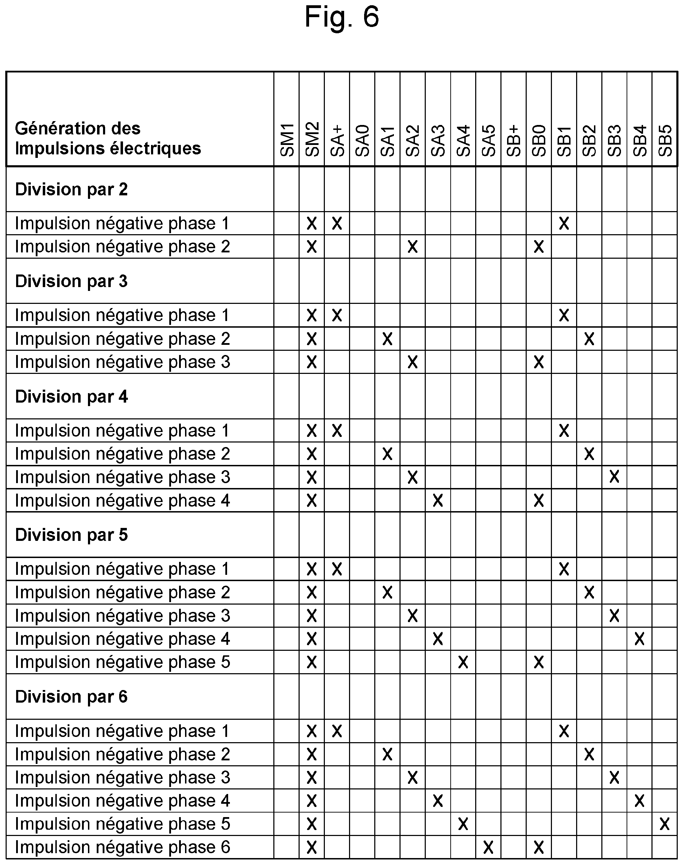

Ensuite, le circuit logique est agencé pour pouvoir ouvrir et fermer les interrupteurs du circuit d'interrupteurs 22 de manière à générer des séries d'impulsions électriques, chacune comprenant S+1 impulsions électriques successives où S est un nombre entier sélectionné entre 1 et N, N étant le nombre de capacités qui est égal à cinq dans la variante représentée. On notera que l'interrupteur (le transistor) est passant/ conducteur lorsqu'il est ouvert et qu'il est non-passant / non-conducteur lorsqu'il est fermé. Dans les tableaux des Figures 5 et 6, lesquels décrivent le mode 'Génération d'impulsions électriques', une croix indique que l'interrupteur / transistor correspondant est ouvert / conducteur, alors qu'une absence de croix indique que l'interrupteur / transistor correspondant est fermé / non-conducteur. Le même principe s'applique pour le tableau de la Figure 4, concernant le mode 'Mesure'.

Chaque série d'impulsions électriques est générée par le circuit logique commandant le circuit d'interrupteurs 22 de la manière suivante :
- premièrement, l'unité d'alimentation 16 est connectée via le stator, pour une durée d'impulsion, au premier condensateur C₁ parmi les cinq condensateurs C₁ à C₅, auquel elle fournit la tension d'alimentation V_{dd}, pour générer ainsi une première impulsion électrique de la série d'impulsions considérée (phase 1 de chacune des divisions possibles énumérées aux Figures 5 et 6) ;
- ensuite, lorsque que le nombre S est égal 2 (division par 3), le stator est connecté, pour la durée d'impulsion, entre le condensateur C₂ et le condensateur C₁ pour générer une deuxième impulsion électrique (phase 2 de la division par 3) ; ou, lorsque que le nombre S de capacités sélectionnées est supérieur à 2 (division par 4, par 5 ou par 6 selon que le nombre S de capacités utilisées est sélectionné respectivement égal à 3, 4 ou 5), le stator est connecté successivement, chaque fois pour la durée d'impulsion, entre un condensateur C_{J} et un condensateur C_{J-1} parmi S condensateurs C₁ à C_{S} déterminés avec J variant de 2 à S, pour générer successivement S-1 impulsions électriques (phase 3 de la division par 4 ; respectivement phase 3 et phase 4 de la division par 5 ; phase 3, phase 4 et phase 5 de la division par 6 ; chacune des phases correspondant à la génération d'une impulsion électrique) ;
- finalement, le stator est connecté, pour la durée d'impulsion, entre le condensateur C_{S} et la masse pour générer une dernière impulsion électrique de la série d'impulsions électriques considérée (dernière phase de chacune des divisions possibles qui sont énumérées dans les tableaux des Figures 5 et 6).

Le nombre S peut être à nouveau sélectionné par le circuit logique lors de chaque nouvelle sélection de la valeur de tension pour la deuxième tension d'alimentation. On remarquera que le tableau de la Figure 5 concerne la commande du circuit d'interrupteurs 22 et des deux interrupteurs de mesure SM1 et SM2 par le circuit logique pour générer des impulsions positives, lesquelles sont prévues lorsque la tension induite dans le stator est positive, de préférence proche d'une tension positive maximale de cette tension induite, alors que le tableau de la Figure 6 concerne la commande du circuit d'interrupteurs 22 et des deux interrupteurs de mesure SM1 et SM2 par le circuit logique pour générer des impulsions négatives, lesquelles sont prévues lorsque la tension induite dans le stator est négative, de préférence proche d'une tension négative maximale de cette tension induite. On notera que pour une valeur S sélectionnée, on peut alternativement engendrer au cours des phases successives qui interviennent des impulsions positives et négatives, de sorte qu'il est possible d'effectuer des impulsions électriques non seulement soit dans des alternances positives, soit dans des alternances négatives de la tension induite, mais aussi alternativement dans des alternances positives et des alternances négatives.

Le diviseur de tension et la méthode de commande de celui-ci pour générer des impulsions électriques motrices est vraiment remarquable, car un régime stationnaire s'établit rapidement dans lequel les différences de tension entre les deux premières bornes (situées du côté du stator) de toutes les paires de capacités, parmi les S capacités sélectionnées, qui sont simultanément connectées respectivement aux deux bornes 26 et 28 du stator, sont sensiblement égales, ces différences de tension étant aussi sensiblement égales à la différence entre la tension d'alimentation Vdd et la tension à la première borne de la capacité C₁ et à la différence entre la tension à la première borne du condensateur C_{S} et la masse (la tension définie par la masse). Ainsi, les impulsions de chaque série d'impulsions électriques sont toutes, en régime stationnaire, générées avec une même tension déterminée qui est sélectionnée. La pluralité de valeurs différentes possibles, pour la tension d'alimentation du stator lors de la génération d'impulsions électriques motrices, correspond respectivement à une pluralité de tensions définie par la tension d'alimentation V_{dd} divisée par m où m = 2 à N+1, m étant égal par définition à S + 1. La pluralité de valeurs différentes pour la deuxième tension d'alimentation (celle appliquée au stator du moteur pour générer au moins une série d'impulsions électriques, de préférence plusieurs séries successives) sont donc respectivement égales à V_{dd} / (S + 1) où S est un nombre, variable entre 1 et N (nombre de capacités de la pluralité de capacités 24) et sélectionnable, de capacités utilisées dans le diviseur de tension pour effectuer une division de la tension d'alimentation V_{dd} par S +1 tout en générant une série de S+1 impulsions électriques. On a donc un diviseur de tension à très haute efficacité qui permet de générer des impulsions électriques motrices avec une tension variable et sélectionnable, dans le mode de réalisation préféré décrit ici en détails, en fonction de plages du taux d'impulsions électriques générées par alternance ou période de la tension induite dans le stator.

Le tableau de la Figure 4 indique les interrupteurs qui sont ouverts (marqués d'une croix) dans le mode de mesure (Mode 'Mesure') intervenant entre des impulsions électriques, en particulier entre chaque paire d'impulsions électriques successives. Au début du mode de mesure, l'interrupteur SM2 est fermé (non-conducteur) et l'interrupteur SM1 est ouvert (conducteur). En fin du mode de mesure, l'interrupteur SM1 est fermé et l'interrupteur SM2 est ouvert, de sorte à connecter à nouveau les deux bobines du stator en série. On différencie en fonction de la division prévue pour la tension d'alimentation (division par S +1, S égal 1 à N = 5), ceci afin d'avoir une tension de référence V_{Ref} qui soit sensiblement égale ou au plus proche de V_{dd} /2 en utilisant les tensions disponibles aux premières bornes des capacités.

En général, dans le mode de réalisation préféré décrit précédemment, les impulsions électriques présentent une durée d'impulsion constante. Cependant, dans une variante particulière, les impulsions électriques présentent une durée d'impulsion qui est constante par intervalle de temps s'étendant sur des dizaines de tours du rotor 6. Ainsi, dans cette variante particulière, il est prévu de varier la quantité d'énergie électrique fournie au moteur en variant aussi la durée des impulsions électriques en plus de la tension fournie au stator, ce qui permet également de limiter la valeur de la tension d'alimentation appliquée au stator et ainsi les pertes résistives dans le moteur. Le circuit logique, qui commande la génération des impulsions électriques, tient compte dans cette variante des changements de la durée des impulsions électriques dans sa gestion du diviseur de tension, notamment pour dénombrer et/ou classifier des paramètres déterminés utilisés dans la sélection du niveau de division pour le diviseur de tension sur la base d'éléments comparables.

Dans un mode de réalisation particulièrement bien adapté au dispositif de commande selon l'invention, ce dispositif de commande est agencé de manière à asservir la vitesse moyenne de rotation du rotor du moteur à une vitesse de consigne donnée. En particulier, cet asservissement de la vitesse de rotation est réalisé de manière similaire à celle décrite dans le document EP 3663872.

L'invention concerne aussi une pièce d'horlogerie, notamment une montre, comprenant un moteur à rotation continue et à courant continu et un dispositif de commande de l'alimentation de ce moteur selon l'un ou l'autre des modes de réalisation du dispositif de commande selon l'invention.

## Revendications

1. Dispositif de commande (2) de l'alimentation d'un moteur à rotation continue (4) qui est formé par un stator et un rotor (6), le stator comprenant au moins une bobine d'alimentation (B1, B2) et le rotor portant au moins un aimant (12a, 12b) agencé de manière à être magnétiquement couplé à ladite au moins une bobine d'alimentation lorsque le rotor tourne, ce dispositif de commande étant agencé pour être alimenté en énergie électrique par une unité d'alimentation (16), fournissant une première tension d'alimentation (Vdd), et comprenant un diviseur de tension (22, 24) agencé pour pouvoir diviser la première tension d'alimentation et fournir au stator une deuxième tension d'alimentation inférieure à la première tension d'alimentation, ce dispositif de commande étant agencé de manière à pouvoir engendrer, dans un mode ou régime de fonctionnement donné du moteur, des impulsions électriques qui sont des impulsions motrices fournies au stator avec ladite deuxième tension d'alimentation pour entraîner le rotor, le nombre de ces impulsions électriques par intervalle de temps défini étant variable en fonction notamment de la charge appliquée au moteur ; **caractérisé en ce que** le diviseur de tension (22, 24) est agencé pour pouvoir fournir ladite deuxième tension d'alimentation avec une pluralité de valeurs différentes et ainsi lesdites impulsions électriques avec une tension variable ; **en ce que** le dispositif de commande (2) comprend un circuit logique (20) qui est agencé pour pouvoir compter les nombres d'impulsions électriques dans des périodes temporelles successives ; pour pouvoir périodiquement sélectionner une valeur de tension, parmi ladite pluralité de valeurs différentes prévues pour la deuxième tension d'alimentation, en fonction d'un nombre d'impulsions électriques compté ou d'une succession de nombres d'impulsions électriques comptés ; et pour pouvoir commander le diviseur de tension de manière que ce diviseur de tension fournisse la deuxième tension d'alimentation avec la valeur de tension sélectionnée lors de la génération d'impulsions électriques suite à la sélection de cette valeur de tension ; et **en ce que** le circuit logique est agencé de manière que, lors de chaque nouvelle sélection :
- la valeur de la deuxième tension d'alimentation est diminuée, si cette valeur est supérieure à une valeur inférieure donnée, lorsqu'un dernier nombre d'impulsions électriques calculé ou une première fonction croissante de ce dernier nombre est inférieur à un premier seuil déterminé, ou lorsque la succession de nombres d'impulsions électriques calculés incluant le dernier nombre ou de la première fonction croissante de chacun de ces nombres valide un premier critère de sélection pour lequel au moins un nombre parmi la succession de nombres ou la première fonction croissante de ce nombre est inférieur à un premier seuil déterminé;
- la valeur de la deuxième tension d'alimentation est augmentée, si cette valeur est inférieure à une valeur supérieure donnée, lorsqu'un dernier nombre d'impulsions électriques calculé ou la première fonction croissante de ce dernier nombre est supérieur à un deuxième seuil déterminé, ou lorsque la succession de nombres d'impulsions électriques calculés incluant le dernier nombre ou de la première fonction croissante de chacun de ces nombres valide un deuxième critère de sélection pour lequel au moins un nombre parmi la succession de nombres ou la première fonction croissante de ce nombre est supérieur à un deuxième seuil déterminé.

2. Dispositif de commande selon la revendication 1, **caractérisé en ce que** le circuit logique (20) est agencé pour pouvoir déterminer dans quelle plage de valeurs, parmi une pluralité de plages de valeurs déterminées, se trouve un nombre d'impulsions électriques calculé ou la première fonction croissante de ce nombre ou une deuxième fonction d'une succession de nombres d'impulsions électriques calculés ou de la première fonction croissante de chacun de ces nombres, et pour pouvoir périodiquement sélectionner une valeur de tension, parmi ladite pluralité de valeurs différentes prévues pour la deuxième tension d'alimentation, en fonction de la dernière plage de valeurs déterminée.

3. Dispositif de commande selon la revendication 2, **caractérisé en ce que** la pluralité de plages de valeurs comprend une première plage de valeurs ayant comme limite supérieure ledit premier seuil, une deuxième plage de valeurs ayant comme limite inférieure ledit deuxième seuil, et une troisième plage de valeurs située entre les première et deuxième plages de valeurs et ayant comme limites inférieure et supérieure respectivement les premier et deuxième seuils ; et **en ce que** le circuit logique (20) est agencé de manière que, lors de chaque nouvelle sélection :
- lorsque le dernier nombre d'impulsions électriques calculé ou la première fonction croissante de ce dernier nombre ou la deuxième fonction de la succession de nombres d'impulsions électriques calculés incluant le dernier nombre ou de la première fonction croissante de chacun de ces nombres est comprise dans la première plage de valeurs, la valeur de la deuxième tension d'alimentation est diminuée si cette valeur est supérieure à ladite valeur inférieure ;
- lorsque le dernier nombre d'impulsions électriques calculé ou la première fonction croissante de ce dernier nombre ou la deuxième fonction de la succession de nombres d'impulsions électriques calculés incluant le dernier nombre ou de la première fonction croissante de chacun de ces nombres est comprise dans la deuxième plage de valeurs, la valeur de la deuxième tension d'alimentation est augmentée si cette valeur est inférieure à ladite valeur supérieure ;
- lorsque le dernier nombre d'impulsions électriques calculé ou la première fonction croissante de ce dernier nombre ou la deuxième fonction de la succession de nombres d'impulsions électriques calculés incluant le dernier nombre ou de la première fonction croissante de chacun de ces nombres est comprise dans la troisième plage de valeurs, la valeur de la deuxième tension d'alimentation est maintenue à une valeur résultant de la sélection précédente.

4. Dispositif de commande selon la revendication 2, **caractérisé en ce que** le dispositif de commande (2) comprend un circuit de mesure (18) agencé pour pouvoir détecter et compter, lorsque le rotor tourne, les alternances ou périodes d'une tension induite dans ladite bobine d'alimentation (B2) ou dans ladite au moins une bobine d'alimentation, les périodes temporelles successives étant chacune définies par un nombre donné d'alternances ou de périodes successives détectées dans la tension induite ; et **en ce que** le circuit logique (20) est agencé pour pouvoir déterminer un taux d'impulsions électriques par alternance ou période de la tension induite pour chacune des périodes temporelles successives, le taux étant égal à la division du nombre d'impulsions électriques compté dans la période temporelle considérée par le nombre donné d'alternances ou de périodes dans cette période temporelle, le taux définissant la première fonction croissante du nombre d'impulsions électriques calculé.

5. Dispositif de commande selon la revendication 4, **caractérisé en ce que** le dispositif de mesure est formé par :
- un comparateur (18a) ayant deux entrées reliées respectivement aux première et seconde bornes (27, 28) de ladite bobine d'alimentation (B2) et fournissant, lorsque le rotor (6) tourne, un signal digital (Pol_B2) indiquant quelle est la polarité instantanée de la tension induite dans cette bobine,
- au moins un premier interrupteur (SM1, SM2) permettant de relier momentanément la première borne (27) de ladite bobine d'alimentation (B2) à une tension de référence qui est inférieure à la première tension d'alimentation, et
- un compteur (18b) agencé pour compter dans ledit signal digital toutes les transitions entre ses deux états, correspondant respectivement aux deux polarités de ladite tension induite, et compter ainsi un nombre d'alternances de cette tension induite, ou toutes les transitions vers un état donné du signal digital et compter ainsi un nombre de périodes de la tension induite.

6. Dispositif de commande selon la revendication 4 ou 5, **caractérisé en ce que** la pluralité de plages de valeurs comprend une plage inférieure dudit taux ayant comme limite supérieure ledit premier seuil, une plage supérieure dudit taux ayant comme limite inférieure ledit deuxième seuil, et une plage intermédiaire dudit taux ayant comme limites inférieure et supérieure respectivement les premier et deuxième seuils ; et **en ce que** le circuit logique est agencé de manière que, lors de chaque nouvelle sélection :
- lorsque le dernier taux d'impulsions électriques déterminé ou la deuxième fonction d'une succession de taux d'impulsions électriques déterminés incluant le dernier taux est compris dans la plage inférieure, la valeur de la deuxième tension d'alimentation est diminuée si cette valeur est supérieure à ladite valeur inférieure ;
- lorsque le dernier taux d'impulsions électriques déterminé ou la deuxième fonction d'une succession de taux d'impulsions électriques déterminés incluant le dernier taux est compris dans la plage intermédiaire, la valeur de la deuxième tension d'alimentation est maintenue à une valeur résultant de la sélection précédente ;
- lorsque le dernier taux d'impulsions électriques déterminé ou la deuxième fonction d'une succession de taux d'impulsions électriques déterminés incluant le dernier taux est compris dans la plage supérieure, la valeur de la deuxième tension d'alimentation est augmentée si cette valeur est inférieure à ladite valeur supérieure.

7. Dispositif de commande selon la revendication 6, **caractérisé en ce que** ledit premier seuil est égal à 50%, ladite plage intermédiaire du taux est comprise entre 50% et 75%, et ledit deuxième seuil est égal à 75%.

8. Dispositif de commande selon une quelconque des revendications précédentes, **caractérisé en ce que** le diviseur de tension comprend un circuit d'interrupteurs (22) agencé entre, d'une part, le stator et, d'autre part, l'unité d'alimentation fournissant la première tension d'alimentation et la masse du dispositif de commande, ce diviseur de tension étant agencé pour pouvoir diviser la première tension d'alimentation sélectivement par une pluralité de nombres entiers qui sont supérieurs à un.

9. Dispositif de commande selon la revendication 8, **caractérisé en ce que** le diviseur de tension comprend N condensateurs Cₙ, n = 1 à N , où N est un nombre entier supérieur à 1 ; **en ce que** le circuit logique est agencé pour pouvoir ouvrir et fermer les interrupteurs dudit circuit d'interrupteurs (22) de manière à générer des séries desdites impulsions électriques, chacune comprenant S+1 impulsions électriques successives où S est un nombre entier sélectionné entre 1 et N, chacune étant générée de la manière suivante :
- premièrement, l'unité d'alimentation est connectée via le stator, pour ladite durée d'impulsion, à un premier condensateur C₁ parmi les N condensateurs, auquel elle fournit la première tension d'alimentation, pour générer une première impulsion électrique de la série d'impulsions considérée ;
- ensuite, lorsque que le nombre S est égal 2, le stator est connecté, pour la durée d'impulsion, entre le condensateur C₂ et le condensateur C₁ pour générer une deuxième impulsion électrique ; ou, lorsque que le nombre S est supérieur à 2, le stator est connecté successivement, chaque fois pour la durée d'impulsion, entre un condensateur C_{J} et un condensateur C_{J-1} parmi S condensateurs, compris dans les N condensateurs, avec J variant de 2 à S, pour générer successivement S-1 impulsions électriques ;
- finalement, le stator est connecté, pour la durée d'impulsion, entre le condensateur C_{S} et la masse pour générer une dernière impulsion électrique de la série d'impulsions électriques considérée ;
et **en ce que** le nombre S peut être à nouveau sélectionné par le circuit logique (20) lors de chaque dite nouvelle sélection de ladite valeur de tension ; ladite pluralité de valeurs différentes prévues pour la deuxième tension d'alimentation correspondant respectivement à la pluralité de tensions définie par la première tension d'alimentation divisée par m où m = 2 à N+1.

10. Dispositif de commande selon la revendication 9, **caractérisé en ce que** les N condensateurs Cn, n = 1 à N, ont une même capacité.

11. Dispositif de commande selon la revendication 9 ou 10, **caractérisé en ce que** le nombre N est prévu entre trois et six, y compris.

12. Dispositif de commande selon une quelconque des revendications 9 à 11, **caractérisé en ce que**, dans ledit mode ou régime de fonctionnement donné du moteur, la première tension d'alimentation divisée par N+1 est supérieure à la valeur absolue d'une tension induite maximale engendrée normalement au travers du stator.

13. Dispositif de commande selon la revendication 12, **caractérisé en ce que** ce dispositif de commande est agencé de manière que chaque impulsion électrique est engendrée lorsque la tension induite au travers du stator est égale à la tension induite maximale

14. Dispositif de commande selon une quelconque des revendications précédentes, **caractérisé en ce que** les impulsions électriques présentent, au moins par intervalle de temps s'étendant sur des dizaines tours du rotor, une durée d'impulsion constante.

15. Dispositif de commande selon une quelconque des revendications précédentes, **caractérisé en ce que** le moteur (4) est un moteur à courant continu.

16. Dispositif de commande selon une quelconque des revendications précédentes, **caractérisé en ce que** ce dispositif de commande est agencé de manière à asservir la vitesse moyenne de rotation du rotor (6) à une vitesse de consigne.

17. Pièce d'horlogerie comprenant un moteur à rotation continue (4) et un dispositif de commande (2) de l'alimentation de ce moteur, **caractérisée en ce que** le dispositif de commande est un dispositif de commande selon une quelconque des revendications précédentes.

## Patentansprüche

1. Steuervorrichtung (2) zur Steuerung der Stromversorgung eines Motors (4) mit kontinuierlicher Drehung, der aus einem Stator und einem Rotor (6) besteht, wobei der Stator mindestens eine Versorgungsspule (B1, B2) umfasst und der Rotor mindestens einen Magneten (12a, 12b) trägt, der so angeordnet ist, dass er magnetisch mit der mindestens einen Versorgungsspule gekoppelt ist, wenn sich der Rotor dreht, wobei diese Steuervorrichtung so angeordnet ist, dass sie von einer Stromversorgungseinheit (16) mit elektrischer Energie versorgt wird, die eine erste Versorgungsspannung (Vdd) liefert, und einen Spannungsteiler (22, 24) umfasst, der so angeordnet ist, dass er die erste Versorgungsspannung teilen und den Stator mit einer zweiten Versorgungsspannung versorgen kann, die niedriger ist als die erste Versorgungsspannung, wobei diese Steuervorrichtung so angeordnet ist, dass sie in einem gegebenen Betriebsmodus oder -zustand des Motors elektrische Impulse erzeugen kann, die Antriebsimpulse sind, die dem Stator mit der zweiten Versorgungsspannung zum Antrieb des Rotors zugeführt werden, wobei die Anzahl dieser elektrischen Impulse pro definiertem Zeitintervall insbesondere in Abhängigkeit von der an den Motor angelegten Last variabel ist; **dadurch gekennzeichnet, dass** der Spannungsteiler (22, 24) so angeordnet ist, dass er die zweite Versorgungsspannung mit einer Vielzahl von unterschiedlichen Werten und somit die elektrischen Impulse mit einer variablen Spannung versorgen kann; dass die Steuervorrichtung (2) eine Logikschaltung (20) umfasst, die so angeordnet ist, dass sie die Anzahl der elektrischen Impulse in aufeinanderfolgenden Zeitperioden zählen kann; so dass sie periodisch einen Spannungswert aus der Vielzahl von verschiedenen Werten, die für die zweite Versorgungsspannung vorgesehen sind, in Abhängigkeit von einer gezählten Anzahl von elektrischen Impulsen oder einer Folge von gezählten Anzahlen von elektrischen Impulsen auswählen kann; und so dass sie den Spannungsteiler so steuern kann, dass dieser Spannungsteiler die zweite Versorgungsspannung mit dem ausgewählten Spannungswert versorgt, wenn er nach der Auswahl dieses Spannungswertes elektrische Impulse erzeugt; und dass die Logikschaltung so angeordnet ist, dass bei jeder neuen Auswahl:
- der Wert der zweiten Versorgungsspannung verringert wird, wenn dieser Wert größer als ein bestimmter niedriger Wert ist, wenn eine letzte berechnete Anzahl von elektrischen Impulsen oder eine erste steigende Funktion dieser letzten Anzahl unter einem ersten bestimmten Schwellenwert liegt, oder wenn die Folge von berechneten Anzahlen von elektrischen Impulsen einschließlich der letzten Anzahl oder der ersten steigenden Funktion jeder dieser Anzahlen ein erstes Auswahlkriterium erfüllt, für das mindestens eine Anzahl unter der Folge von Anzahlen oder der ersten steigenden Funktion dieser Anzahl unter einem ersten bestimmten Schwellenwert liegt;
- der Wert der zweiten Versorgungsspannung erhöht wird, wenn dieser Wert kleiner als ein gegebener hoher Wert ist, wenn eine letzte berechnete Anzahl von elektrischen Impulsen oder die erste ansteigende Funktion dieser letzten Anzahl über einem zweiten bestimmten Schwellenwert liegt, oder wenn die Folge von berechneten Anzahlen von elektrischen Impulsen einschließlich der letzten Anzahl oder der ersten ansteigenden Funktion jeder dieser Anzahlen ein zweites Auswahlkriterium erfüllt, für das mindestens eine Anzahl aus der Folge von Anzahlen oder der ersten ansteigenden Funktion dieser Anzahl über einem zweiten bestimmten Schwellenwert liegt.

2. Steuervorrichtung nach Anspruch 1, **dadurch gekennzeichnet, dass** die Logikschaltung (20) derart angeordnet ist, dass sie ermitteln kann, in welchem Wertebereich aus einer Vielzahl von ermittelten Wertebereichen eine berechnete Anzahl von elektrischen Impulsen oder die erste steigende Funktion dieser Anzahl oder eine zweite Funktion einer Folge von berechneten Anzahlen von elektrischen Impulsen oder der ersten steigenden Funktion jeder dieser Anzahlen liegt, und dass sie periodisch einen Spannungswert aus der Vielzahl von verschiedenen für die zweite Versorgungsspannung vorgesehenen Werten in Abhängigkeit von dem zuletzt ermittelten Wertebereich auswählen kann.

3. Steuervorrichtung nach Anspruch 2, **dadurch gekennzeichnet, dass** die Vielzahl von Wertebereichen einen ersten Wertebereich mit dem ersten Schwellenwert als oberer Grenze, einen zweiten Wertebereich mit dem zweiten Schwellenwert als unterer Grenze und einen dritten Wertebereich umfasst, der zwischen dem ersten und dem zweiten Wertebereich liegt und den ersten und den zweiten Schwellenwert als untere bzw. obere Grenze aufweist, und dass die Logikschaltung (20) so angeordnet ist, dass bei jeder neuen Auswahl:
- wenn die letzte berechnete Anzahl von elektrischen Impulsen oder die erste ansteigende Funktion dieser letzten Anzahl oder die zweite Funktion der Folge von berechneten Anzahlen von elektrischen Impulsen einschließlich der letzten Anzahl oder der ersten ansteigenden Funktion jeder dieser Zahlen innerhalb des ersten Wertebereichs liegt, der Wert der zweiten Versorgungsspannung verringert wird, wenn dieser Wert größer als der genannte niedrige Wert ist;
- wenn die letzte berechnete Anzahl von elektrischen Impulsen oder die erste ansteigende Funktion dieser letzten Anzahl oder die zweite Funktion der Folge von berechneten Anzahlen von elektrischen Impulsen einschließlich der letzten Anzahl oder der ersten ansteigenden Funktion jeder dieser Anzahlen innerhalb des zweiten Wertebereichs liegt, der Wert der zweiten Versorgungsspannung erhöht wird, wenn dieser Wert kleiner als der genannte hohe Wert ist;
- wenn die letzte berechnete Anzahl von elektrischen Impulsen oder die erste ansteigende Funktion dieser letzten Anzahl oder die zweite Funktion der Folge von berechneten Anzahlen von elektrischen Impulsen einschließlich der letzten Anzahl oder der ersten ansteigenden Funktion jeder dieser Anzahlen innerhalb des dritten Wertebereichs liegt, der Wert der zweiten Versorgungsspannung auf einem Wert gehalten wird, der sich aus der vorherigen Auswahl ergibt.

4. Steuervorrichtung nach Anspruch 2, **dadurch gekennzeichnet, dass** die Steuervorrichtung (2) eine Messschaltung (18) umfasst, die so angeordnet ist, dass sie bei Drehung des Rotors die Wechsel oder Perioden einer induzierten Spannung in der Versorgungsspule (B2) oder in der mindestens einen Versorgungsspule erfassen und zählen kann, wobei die aufeinanderfolgenden Zeitperioden jeweils durch eine gegebene Anzahl von aufeinanderfolgenden, in der induzierten Spannung erfassten Wechseln oder Perioden definiert sind; und dass die Logikschaltung (20) so angeordnet ist, dass sie eine elektrische Impulsrate pro Wechsel oder Periode der induzierten Spannung für jede der aufeinanderfolgenden Zeitperioden bestimmen kann, wobei die Rate gleich der Division der Anzahl der in der betrachteten Zeitperiode gezählten elektrischen Impulse durch die gegebene Anzahl von Wechseln oder Perioden in dieser Zeitperiode ist, wobei die Rate die erste ansteigende Funktion der berechneten Anzahl von elektrischen Impulsen definiert.

5. Steuervorrichtung nach Anspruch 4, **dadurch gekennzeichnet, dass** die Messvorrichtung gebildet wird durch:
- einen Komparator (18a), der zwei Eingänge hat, die mit dem ersten bzw. zweiten Anschluss (27, 28) der Versorgungsspule (B2) verbunden sind, und der bei Drehung des Rotors (6) ein digitales Signal (Pol_B2) liefert, das die momentane Polarität der in dieser Spule induzierten Spannung angibt,
- mindestens einen ersten Schalter (SM1, SM2), der es ermöglicht, den ersten Anschluss (27) der Versorgungsspule (B2) vorübergehend mit einer Referenzspannung zu verbinden, die geringer ist als die erste Versorgungsspannung, und
- einen Zähler (18b), der so beschaffen ist, dass er in dem digitalen Signal alle Übergänge zwischen seinen beiden Zuständen zählt, die jeweils den beiden Polaritäten der induzierten Spannung entsprechen, und somit eine Anzahl von Wechseln dieser induzierten Spannung zählt, oder alle Übergänge zu einem bestimmten Zustand des digitalen Signals zählt und somit eine Anzahl von Perioden der induzierten Spannung zählt.

6. Steuervorrichtung nach Anspruch 4 oder 5, **dadurch gekennzeichnet, dass** die Vielzahl von Wertebereichen einen unteren Bereich der Rate mit dem ersten Schwellenwert als oberer Grenze, einen oberen Bereich der Rate mit dem zweiten Schwellenwert als unterer Grenze und einen Zwischenbereich der Rate mit dem ersten und dem zweiten Schwellenwert als unterer bzw. oberer Grenze umfasst; und dass die Logikschaltung so angeordnet ist, dass bei jeder neuen Auswahl:
- wenn die letzte ermittelte elektrische Impulsrate oder die zweite Funktion einer Folge ermittelter elektrischer Impulsraten einschließlich der letzten Rate innerhalb des unteren Bereichs liegt, der Wert der zweiten Versorgungsspannung verringert wird, wenn dieser Wert über dem unteren Wert liegt;
- wenn die letzte ermittelte elektrische Impulsrate oder die zweite Funktion einer Folge von ermittelten elektrischen Impulsraten einschließlich der letzten Rate innerhalb des Zwischenbereichs liegt, der Wert der zweiten Versorgungsspannung auf einem Wert gehalten wird, der sich aus der vorherigen Auswahl ergibt;
- wenn die letzte ermittelte elektrische Impulsrate oder die zweite Funktion einer Folge ermittelter elektrischer Impulsraten einschließlich der letzten Rate innerhalb des oberen Bereichs liegt, der Wert der zweiten Versorgungsspannung erhöht wird, wenn dieser Wert unter dem hohen Wert liegt.

7. Steuervorrichtung nach Anspruch 6, **dadurch gekennzeichnet, dass** der erste Schwellenwert gleich 50 % ist, der Zwischenbereich der Rate zwischen 50 % und 75 % liegt und der zweite Schwellenwert gleich 75 % ist.

8. Steuervorrichtung nach einem der vorhergehenden Ansprüche, **dadurch gekennzeichnet, dass** der Spannungsteiler einen Schaltkreis (22) umfasst, der zwischen dem Stator einerseits und dem die erste Versorgungsspannung liefernden Netzteil andererseits und der Masse der Steuervorrichtung angeordnet ist, wobei dieser Spannungsteiler so angeordnet ist, dass er die erste Versorgungsspannung selektiv durch mehrere ganze Zahlen größer als eins teilen kann.

9. Steuervorrichtung nach Anspruch 8, **dadurch gekennzeichnet, dass** der Spannungsteiler N Kondensatoren Cₙ umfasst, n = 1 bis N, wobei N eine ganze Zahl größer als 1 ist; dass die Logikschaltung dann so beschaffen ist, dass sie die Schalter des Schaltkreises (22) öffnen und schließen kann, um Serien der elektrischen Impulse zu erzeugen, die jeweils S+1 aufeinanderfolgende elektrische Impulse umfassen, wobei S eine ganze Zahl zwischen 1 und N ist, die jeweils wie folgt erzeugt wird:
- erstens ist das Netzteil über den Stator für die genannte Impulsdauer mit einem ersten Kondensator C₁ unter den N Kondensatoren verbunden, an den es die erste Versorgungsspannung liefert, um einen ersten elektrischen Impuls der betrachteten Impulsreihe zu erzeugen;
- dann, wenn die Zahl S gleich 2 ist, wird der Stator für die Dauer des Impulses zwischen den Kondensator C₂ und den Kondensator C₁ geschaltet, um einen zweiten elektrischen Impuls zu erzeugen; oder, wenn die Zahl S größer als 2 ist, wird der Stator nacheinander, jedes Mal für die Dauer des Impulses, zwischen einen Kondensator C_{J} und einen Kondensator C_{J-1} unter S Kondensatoren, die in den N Kondensatoren enthalten sind, geschaltet, wobei J von 2 bis S variiert, um nacheinander S-1 elektrische Impulse zu erzeugen;
- schließlich wird der Stator für die Dauer des Impulses zwischen den Kondensator C_{S} und die Masse geschaltet, um einen letzten elektrischen Impuls der betrachteten Reihe von elektrischen Impulsen zu erzeugen;
und dass die Zahl S von der Logikschaltung (20) bei jeder neuen Auswahl des Spannungswerts neu gewählt werden kann; wobei die mehreren verschiedenen Werte, die für die zweite Versorgungsspannung vorgesehen sind, jeweils den mehreren Spannungen entsprechen, die durch die erste Versorgungsspannung geteilt durch m definiert sind, wobei m = 2 bis N+1.

10. Steuergerät nach Anspruch 9, **dadurch gekennzeichnet, dass** die N Kondensatoren Cn, n = 1 bis N, die gleiche Kapazität haben.

11. Steuervorrichtung nach Anspruch 9 oder 10, **dadurch gekennzeichnet, dass** die Zahl N zwischen drei und einschließlich sechs liegen soll.

12. Steuervorrichtung nach einem der Ansprüche 9 bis 11, **dadurch gekennzeichnet, dass** in der gegebenen Betriebsart oder dem gegebenen Betriebszustand des Motors die erste Versorgungsspannung geteilt durch N+1 größer ist als der Absolutwert einer maximalen induzierten Spannung, die normalerweise am Stator erzeugt wird.

13. Steuervorrichtung nach Anspruch 12, **dadurch gekennzeichnet, dass** diese Steuervorrichtung so angeordnet ist, dass jeder elektrische Impuls erzeugt wird, wenn die induzierte Spannung am Stator gleich der maximalen induzierten Spannung ist.

14. Steuervorrichtung nach einem der vorhergehenden Ansprüche, **dadurch gekennzeichnet, dass** die elektrischen Impulse eine konstante Impulsdauer aufweisen, zumindest pro Zeitintervall, das sich über mehrere zehn Umdrehungen des Rotors erstreckt.

15. Steuervorrichtung nach einem der vorhergehenden Ansprüche, **dadurch gekennzeichnet, dass** der Motor (4) ein Gleichstrommotor ist.

16. Steuervorrichtung nach einem der vorhergehenden Ansprüche, **dadurch gekennzeichnet, dass** diese Steuervorrichtung so beschaffen ist, dass sie die mittlere Drehzahl des Rotors (6) so steuert, dass sie einer Solldrehzahl entspricht.

17. Teil für die Uhrmacherei mit einem Motor (4) mit kontinuierlicher Drehbewegung und einer Steuervorrichtung (2) zur Steuerung der Stromversorgung dieses Motors, **dadurch gekennzeichnet, dass** die Steuervorrichtung eine Steuervorrichtung nach einem der vorhergehenden Ansprüche ist.

## Claims

1. Control device (2) for controlling the power supply to a continuous-rotation motor (4) which is formed by a stator and a rotor (6), the stator comprising at least one supply coil (B1, B2) and the rotor carrying at least one magnet (12a, 12b) arranged so as to be magnetically coupled to said at least one supply coil when the rotor is rotating, this control device being arranged to be supplied with electrical power by a power supply unit (16), supplying a first supply voltage (Vdd), and comprising a voltage divider (22, 24) arranged such that it can divide the first supply voltage and supply the stator with a second supply voltage that is lower than the first supply voltage, this control device being arranged such that it can generate, in a given operating mode or regime of the motor, electrical pulses which are driving pulses supplied to the stator with said second supply voltage for driving the rotor, the number of these electrical pulses per defined time interval being variable as a function in particular of the load applied to the motor; **characterised in that** the voltage divider (22, 24) is arranged such that it can supply said second supply voltage with a plurality of different values and thus said electrical pulses with a variable voltage; **in that** the control device (2) comprises a logic circuit (20) which is arranged such that it can count the numbers of electrical pulses in successive time periods; such that it can periodically select a voltage value, from among said plurality of different values provided for the second supply voltage, as a function of a counted number of electrical pulses or of a succession of counted numbers of electrical pulses; and such that it can control the voltage divider so that this voltage divider supplies the second supply voltage with the selected voltage value when generating electrical pulses after the selection of this voltage value; and **in that** the logic circuit is arranged such that, with each new selection:
- the value of the second supply voltage is reduced, if this value is greater than a given low value, when a last calculated number of electrical pulses or a first increasing function of this last number is below a first determined threshold, or when the succession of calculated numbers of electrical pulses including the last number or of the first increasing function of each of these numbers satisfies a first selection criterion for which at least one number among the succession of numbers or the first increasing function of this number is below a first determined threshold;
- the value of the second supply voltage is increased, if this value is less than a given high value, when a last calculated number of electrical pulses or the first increasing function of this last number is above a second determined threshold, or when the succession of calculated numbers of electrical pulses including the last number or of the first increasing function of each of these numbers satisfies a second selection criterion for which at least one number among the succession of numbers or the first increasing function of this number is above a second determined threshold.

2. Control device according to claim 1, **characterised in that** the logic circuit (20) is arranged such that it can determine in which value range, from among a plurality of determined value ranges, lies a calculated number of electrical pulses or the first increasing function of this number or a second function of a succession of calculated numbers of electrical pulses or of the first increasing function of each of these numbers, and such that it can periodically select a voltage value, from among said plurality of different values provided for the second supply voltage, as a function of the last determined value range.

3. Control device according to claim 2, **characterised in that** the plurality of value ranges comprises a first value range having as an upper limit said first threshold, a second value range having as a lower limit said second threshold, and a third value range located between the first and second value ranges and having the first and second thresholds as a lower and upper limit respectively; and **in that** the logic circuit (20) is arranged such that, with each new selection:
- when the last calculated number of electrical pulses or the first increasing function of this last number or the second function of the succession of calculated numbers of electrical pulses including the last number or of the first increasing function of each of these numbers is within the first value range, the value of the second supply voltage is decreased if this value is greater than said low value;
- when the last calculated number of electrical pulses or the first increasing function of this last number or the second function of the succession of calculated numbers of electrical pulses including the last number or of the first increasing function of each of these numbers is within the second value range, the value of the second supply voltage is increased if this value is less than said high value;
- when the last calculated number of electrical pulses or the first increasing function of this last number or the second function of the succession of calculated numbers of electrical pulses including the last number or of the first increasing function of each of these numbers is within the third value range, the value of the second supply voltage is maintained at a value resulting from the previous selection.

4. Control device according to claim 2, **characterised in that** the control device (2) comprises a measuring circuit (18) arranged such that it can detect and count, when the rotor is rotating, the alternations or periods of an induced voltage in said supply coil (B2) or in said at least one supply coil, the successive time periods each being defined by a given number of successive alternations or periods detected in the induced voltage; and **in that** the logic circuit (20) is arranged such that it can determine an electrical pulse rate per alternation or period of the induced voltage for each of the successive time periods, the rate being equal to the division of the number of electrical pulses counted in the time period considered by the given number of alternations or periods in this time period, the rate defining the first increasing function of the calculated number of electrical pulses.

5. Control device according to claim 4, **characterised in that** the measuring device is formed by:
- a comparator (18a) having two inputs respectively connected to the first and second terminals (27, 28) of said supply coil (B2) and providing, when the rotor (6) rotates, a digital signal (Pol_B2) indicating the instantaneous polarity of the induced voltage in this coil,
- at least one first switch (SM1, SM2) allowing the first terminal (27) of said supply coil (B2) to be momentarily connected to a reference voltage that is less than the first supply voltage, and
- a counter (18b) arranged to count, in said digital signal, all the transitions between its two states, respectively corresponding to the two polarities of said induced voltage, and thus count a number of alternations of this induced voltage, or all the transitions to a given state of the digital signal and thus count a number of periods of the induced voltage.

6. Control device according to claim 4 or 5, **characterised in that** the plurality of value ranges comprises a lower range of said rate having said first threshold as the upper limit, an upper range of said rate having said second threshold as the lower limit, and an intermediate range of said rate having the first and second thresholds as the lower and upper limits respectively; and **in that** the logic circuit is arranged such that, with each new selection:
- when the last determined electrical pulse rate or the second function of a succession of determined electrical pulse rates including the last rate is within the lower range, the value of the second supply voltage is decreased if this value is greater than said low value;
- when the last determined electrical pulse rate or the second function of a succession of determined electrical pulse rates including the last rate is within the intermediate range, the value of the second supply voltage is maintained at a value resulting from the previous selection;
- when the last determined electrical pulse rate or the second function of a succession of determined electrical pulse rates including the last rate is within the upper range, the value of the second supply voltage is increased if this value is less than said high value.

7. Control device according to claim 6, **characterised in that** said first threshold is equal to 50%, said intermediate rate range is between 50% and 75%, and said second threshold is equal to 75%.

8. Control device according to any one of the preceding claims, **characterised in that** the voltage divider comprises a switch circuit (22) arranged between, on the one hand, the stator and, on the other hand, the power supply unit supplying the first supply voltage and the ground of the control device, this voltage divider being arranged such that it can divide the first supply voltage selectively by a plurality of integers greater than one.

9. Control device according to claim 8, **characterised in that** the voltage divider comprises N capacitors Cₙ, n = 1 to N, where N is an integer greater than 1; **in that** the logic circuit is then arranged such that it can open and close the switches of said switch circuit (22) so as to generate series of said electrical pulses, each comprising S+1 successive electrical pulses, where S is an integer selected between 1 and N, each being generated as follows:
- firstly, the power supply unit is connected via the stator, for said pulse duration, to a first capacitor C₁ among the N capacitors, to which it supplies the first supply voltage, in order to generate a first electrical pulse of the pulse series considered;
- then, when the number S is equal to 2, the stator is connected, for the pulse duration, between the capacitor C₂ and the capacitor C₁ in order to generate a second electrical pulse; or, when the number S is greater than 2, the stator is successively connected, each time for the pulse duration, between a capacitor C_{J} and a capacitor C_{J-1} among S capacitors, included in the N capacitors, where J varies from 2 to S, in order to successively generate S-1 electrical pulses;
- finally, the stator is connected, for the pulse duration, between the capacitor C_{S} and the ground in order to generate a last electrical pulse of the series of electrical pulses considered;
and **in that** the number S can be re-selected by the logic circuit (20) upon each new selection of said voltage value; said plurality of different values provided for the second supply voltage respectively corresponding to the plurality of voltages defined by the first supply voltage divided by m, where m = 2 to N+1.

10. Control device according to claim 9, **characterised in that** the N capacitors Cn, n = 1 to N, have the same capacitance.

11. Control device according to claim 9 or 10, **characterised in that** the number N is intended to be between three and six, inclusive.

12. Control device according to any one of claims 9 to 11, **characterised in that**, in said given operating mode or regime of the motor, the first supply voltage divided by N+1 is greater than the absolute value of a maximum induced voltage normally generated across the stator.

13. Control device according to claim 12, **characterised in that** this control device is arranged such that each electrical pulse is generated when the induced voltage across the stator is equal to the maximum induced voltage.

14. Control device according to any one of the preceding claims, **characterised in that** the electrical pulses have a constant pulse duration, at least per time interval extending over tens of revolutions of the rotor.

15. Control device according to any one of the preceding claims, **characterised in that** the motor (4) is a DC motor.

16. Control device according to any one of the preceding claims, **characterised in that** this control device is arranged to control the average rotational speed of the rotor (6) such that it equals a setpoint speed.

17. Timepiece comprising a continuous-rotation motor (4) and a control device (2) for controlling the power supply to this motor, **characterised in that** the control device is a control device according to any one of the preceding claims.
